# EUROPEAN PATENT SPECIFICATION

(11) **EP 3 684 230 B1**
(45) Date of publication and mention of the grant of the patent: **29.06.2022**
(21) Application number: 18857976.7
(22) Date of filing: 12.09.2018
(51) Int. Cl.: A47F 11/10, A47B 97/00, A47B 47/00, F21V 21/35, A47B 91/00

(54) **SHELF SYSTEM**
REGALSYSTEM
SYSTÈME D'ÉTAGÈRE

(30) Priority: 21.09.2017 FI 20175836
(43) Date of publication of application: 29.07.2020
(73) Proprietor: Simple Furniture Group Oy, 02150 Espoo (FI)
(72) Inventor: MAHLBERG, Stefan, 02150 Espoo (FI)
(74) Representative: Primrose Oy
(86) International application number: PCT/FI2018/050649
(87) International publication number: WO 2019/058023

(56) References cited:
- WO-A1-2013/013692
- WO-A1-2013/013692
- WO-A2-2008/029333
- WO-A2-2008/029333
- DE-A1- 3 918 193
- JP-A- 2001 250 420
- US-A1- 2004 228 122
- US-A1- 2004 228 122
- US-A1- 2015 092 397
- US-B1- 6 231 205
- US-B2- 9 228 735

## Description

### FIELD OF THE INVENTION

The present invention relates to a shelf system and more particularly to a shelf system as defined in the preamble of the independent claim 1.

### BACKGROUND OF THE INVENTION

It is known in the prior art that shelves such as book shelves can be provided with electrical devices such as lighting systems that are arranged as a surface mounting to the shelf when the shelf is assembled. In this kind of shelves when the shelf is assembled a light source will be mounted on a surface of a shelf plate and electrical wiring will be attached on the surface of the shelf plate. The electrical wiring is lead along the surface of the shelf plate and along the surface of the shelf structure until it will be connected to a power source.

Document WO 2008/029333 discloses an electrically powered modular furniture system a first furniture member equipped with a low voltage electrical fixture, secured to a main surface of said first furniture member, and with low voltage conduit means comprising a pair of co-operating apertured conductor rails secured in an interfacial arrangement to a main surface of said first furniture member.

One of the problems associated with the prior art is that once the shelf is assembled and the lighting system is connected to a shelf plate and the electrical wiring is attached to the shelf connecting the lighting system to a power source the shelf plate can no longer be repositioned in the shelf without detaching the electrical wiring from the shelf plate and attaching it again when the shelf plate is positioned in a new location.

### BRIEF DESCRIPTION OF THE INVENTION

An object of the present invention is to provide a shelf system in which an electrical device is provided in connection with the shelf system and in particularly in connection with a shelf of the shelf system and such that electricity to the electrical device is provided internally in the structure of the shelf system. A further object of the present invention is to provide a shelf system which is provided with electricity in such a way that the shelf system is easy to assemble.

The objects of the invention are achieved by a shelf system which is characterized by what is stated in the independent claim. The preferred embodiments of the invention are disclosed in the dependent claims.

The invention is based on the idea of providing a shelf system which comprises two or more side walls and one or more shelf plates arranged between two side walls. Each side wall comprises a top end and a bottom end and a first side surface extending between the top end and the bottom end and a second side surface on the other side of the side wall, i.e. on the opposing side of the side wall, extending between the top end and the bottom end. The side walls further comprise side wall apertures extending from the first side surface inwards into the side wall. In another embodiment of the invention when there are two shelf plates arranged on different sides of the same side wall then the second side surface also comprises side wall apertures extending from the second side surface inwards into the side wall. The shelf plates are arranged between two side walls with two or more shelf supports. The two or more shelf supports are provided in the side wall apertures for supporting one or more shelf plates to the side walls.

In the shelf system according to the invention at least one of the two or more side walls comprises a wall conductor arranged to extend inside the side wall between the top end and the bottom end and at least one of side wall apertures extend from the first side surface to the wall conductor. Further at least one of the one or more shelf plates comprises an electrical device and at least one of the two or more shelf supports is made of electrically conductive material and arranged in contact with the wall conductor in the side wall and further in contact with the electrical device in the shelf plate. Said at least one of the two or more shelf supports connecting the side wall comprising the wall conductor and the shelf plate comprising the electrical device is arranged to provide an electrical connection between the wall conductor and the electrical device. In other words, the shelf support is arranged to transfer electricity from the side wall comprising the wall conductor to the shelf plate comprising the electrical device. The electrical device can be a light source, an USB connector, a loudspeaker, an electrical socket, a wireless charging platform, a camera, a screen or other suitable electrical device in connection with a shelf plate in a shelf system.

Power supply from a power supply source, such as from a power socket, to the shelf system and especially to the wall conductor arranged in the side wall is provided through a power supply port. In the embodiment in which the shelf system comprises only side walls and shelf plates the power supply port can be arranged to the side wall comprising the conductor. In other words, the power supply port is arranged in the at least one of the two or more side walls. Preferably between the power supply source and the power supply port there is a transformer for converting mains power to fit for the electrical device.

According to the invention the shelf system is further provided with a bottom structure such that the side walls are supported by the bottom structure. The power supply port is preferably arranged to the bottom structure such that power supply from a power source to the wall conductor and further to the electrical device in connection with the shelf plate is arranged through the bottom structure comprising a conductor for transferring electricity from the power source to the electrical device through the side wall comprising the wall conductor. The conductor in the bottom structure is in an electrical connection with the wall conductor in the side wall. According to the invention the bottom structure comprises at least two base members, a bottom plate arranged between two base members, and a coupling connecting the bottom plate to the two base members. The power supply port is preferably arranged in the base member or in the bottom plate. The wall conductor is an electrical wire, an electrical strip or a plate conductor set as a single conductor, as a conductor pair, as a set of conductors or as a conductor net inside the side wall.

The wall conductor is arranged to extend inside the side wall between the top end and the bottom end of the side wall. The wall conductor may extend to the bottom end of the side wall such that the wall conductor forms part of the bottom structure of the side wall. This is especially advantageous when the shelf system comprises a bottom structure in which a conductor is arranged such that the conductor of the bottom structure is in contact with the wall conductor for transferring electricity between the bottom structure and the side wall comprising the wall conductor.

The shelf system comprises a bottom structure which comprises at least two base members, a bottom plate arranged between the two base members and a coupling connecting the bottom plate to the two base members. As earlier explained the bottom structure may comprise at least one conductor. The base member comprises a base conductor and/or the bottom plate comprises a bottom conductor. The bottom conductor is preferably electrically connected to the base conductor through an electrical connection.

An advantage of the invention is that a place of a shelf plate comprising an electrical device such as a light can be changed without the need for touching the electricity so that when the shelf plate is changed to another place the electrical device receives electricity without any need for re-modification to electrical connection between the electrical device and the power source. In other words, an advantage of the invention is that electricity is transferred inside the side wall and through a shelf support to the electrical device in connection with the shelf plate such that the place of the shelf plate can be changed without any modification to the power supply since there is no wiring between the shelf and the shelf plate.

### BRIEF DESCRIPTION OF THE DRAWINGS

The invention is described in detail by means of specific embodiments with reference to the enclosed drawings, in which
Figure 1a shows a side wall of a shelf system according to one example not according to the invention;
Figure 1b shows the side wall of figure 1a as a side view;
Figure 2a shows a side wall of a shelf system according to the invention;
Figure 2b shows the side wall of figure 2a as a side view;
Figure 3a shows a side wall of a shelf system
Figure 3b shows the side wall of figure 3a as a side view;
Figure 4a shows a side view of a side wall
Figure 4b shows a side view of another side wall not according to the invention;
Figure 5a shows a shelf plate of a shelf system according to the invention;
Figure 5b shows another shelf plate of a shelf system not according to the invention;
Figure 5c shows yet another shelf plate of a shelf system not according to the invention;
Figure 6 shows a shelf system according not according to the invention;
Figure 7 shows another shelf system not according to the invention;
Figure 8a shows a base member of a shelf system not according to the invention;
Figure 8b shows the base member shown in figure 8a from above;
Figure 9 shows a detail of a base structure of a shelf system in an example not according to the invention;
Figure 10a shows a base member of a shelf system according to an example not according to the invention;
Figure 10b shows the base member shown in figure 10a from above;
Figure 11 shows part of a bottom structure of a shelf system not according to the invention;
Figure 12a shows an embodiment of the base conductor;
Figure 12b shows another embodiment of the base conductor; and
Figure 12c shows yet another embodiment of the base conductor.

### DETAILED DESCRIPTION OF THE INVENTION

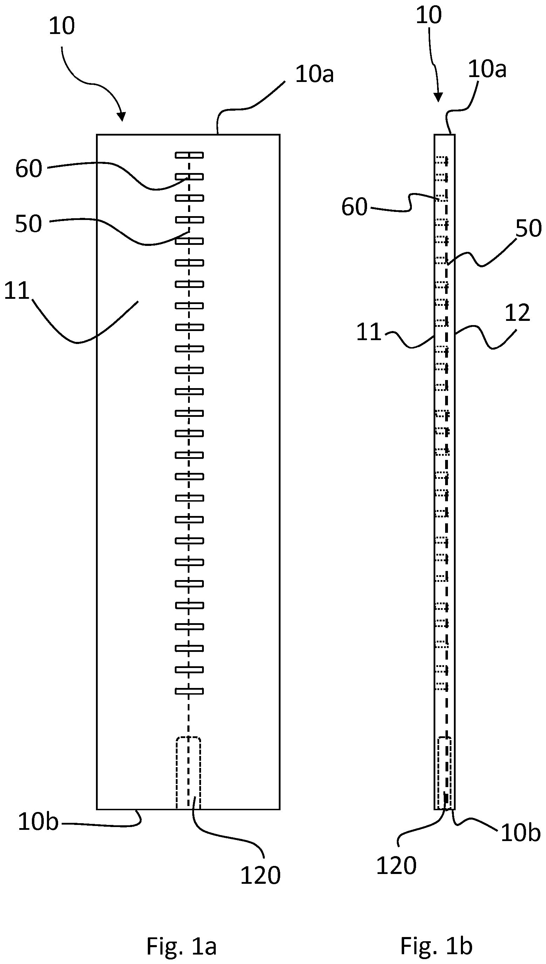

Figure 1a shows a side wall 10 of a shelf system 1 not according the invention. The side wall 10 comprises a top end 10a and a bottom end 10b which is intended to be arranged on a surface, the surface being a floor surface or a separate bottom structure which is explained later.

The side wall 1 comprises a first side surface 11 extending between the top end 10a and the bottom end 10b and side wall apertures 60 extending from the first side surface 11 inwards into the side wall 10. The side wall further comprises a wall conductor 50 arranged to extend inside the side wall 10 between the top end 10a and the bottom end 10b and at least one of the side wall apertures 60 extending from the first side surface 11 to the wall conductor 50. At least one of the side wall apertures 60 is arranged as a blind hole in the side wall 10 such that the wall conductor 50 forms part of the blind hole.

In this example shown in figure 1a the side wall comprises a wall conductor 50 which is a single electrical wire or a single electrical strip or a single plate conductor. The wall conductor 50 as shown in figure 1a is arranged inside the side wall 10 in a longitudinal direction from the bottom end 10b to the top end 10a. The wall conductor 50 can be arranged inside the side wall 10 such that it is arranged to extend only part of the length of the side wall 10 or only a part of the width of the side wall 10. In the embodiment shown in figure 1a the wall conductor 50 is arranged to extend from the upper part of the side wall 10 and particularly from the upper most side wall aperture 60 to the bottom end 10b of the side wall 10.

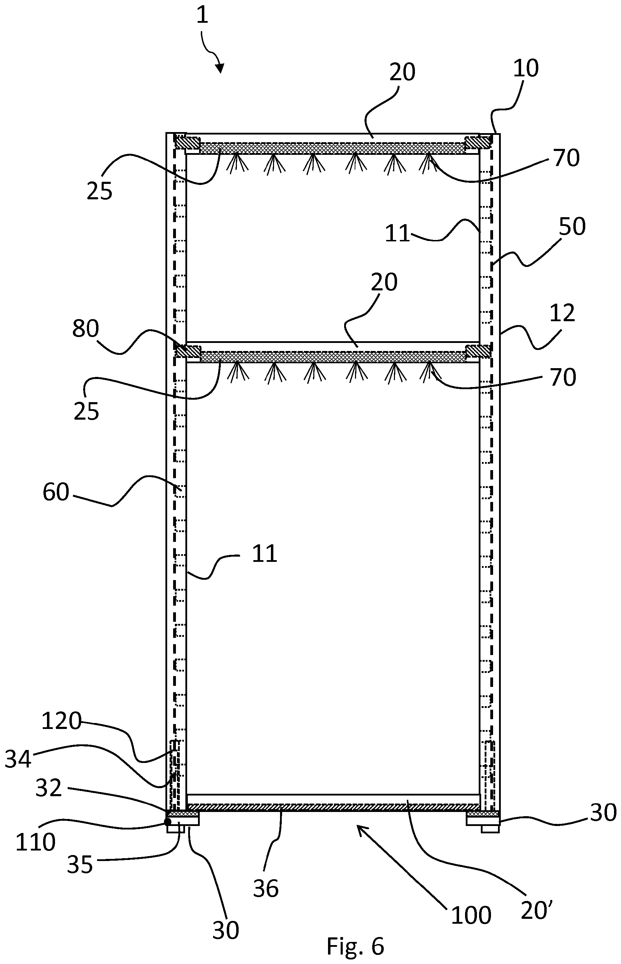

Figure 1a also shows a support aperture 120 into which a standing support of a bottom structure can be inserted (the bottom structure is explained in connection with figures 6-11). When a power supply port is arranged to the bottom structure, which means that power supply from a power source to the wall conductor 50 inside the side wall 10 is supplied through the bottom structure, the bottom structure comprises a conductor for transferring electricity from the power source to the wall conductor 50 inside the side wall 10 and the wall conductor 50 of the side wall 10 extends to the bottom end 10b of the side wall 10 such that an electrical connection with the conductor of the bottom structure is established. When the bottom structure comprises a standing support to be inserted in the support aperture 120 the standing support preferably comprises a conductor and the wall conductor 50 extends to the support aperture 120 such that electrical connection is provided between the wall conductor 50 in the side wall 10 and a conductor in the bottom structure. Another way the establish an electrical connection with the wall conductor 50 and the bottom structure is that the wall conductor 50 extends to the bottom end 10b of the side wall 10 and the bottom structure comprises a conductor such that the wall conductor and the conductor in the bottom structure contact each other.

Figure 1b shows the side wall 10 as shown in figure 1a as a side view. The side wall 10 has a first side surface 11 and a second side surface 12 extending between the top end 10a and the bottom end 10b and the side wall apertures 60 are arranged to extend from the first side surface 11 to the wall conductor 50 arranged inside the side wall 10 such that the wall conductor 50 forms part of the side wall apertures 60. The wall conductor 50 extends to the support aperture 120 forming part of the support aperture 120 such that when a standing support of a bottom structure comprising a conductor is inserted into the support aperture 120 an electrical connection is established between the wall conductor 50 and the conductor of the bottom structure.

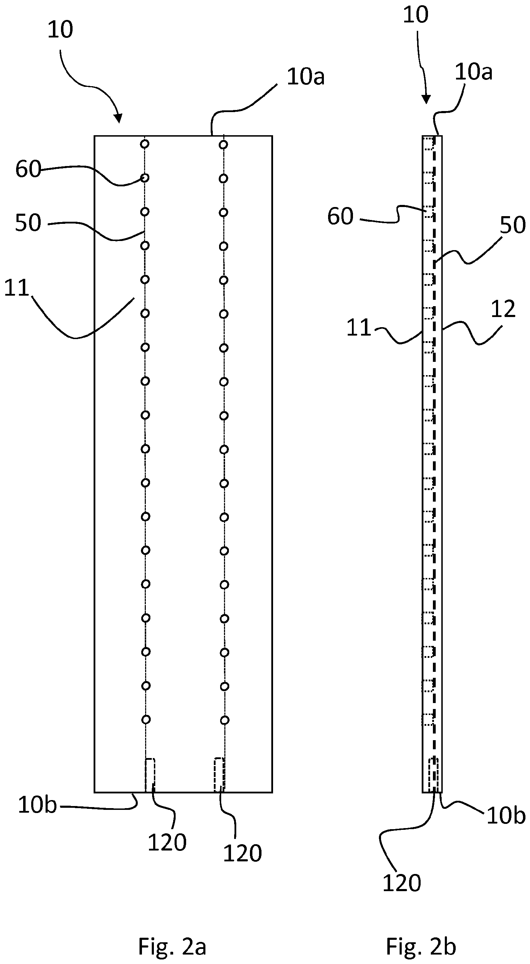

Figure 2a shows a side wall 10 of a shelf system 1 according to the invention in which the side wall 10 comprises a pair of conductors 50 arranged inside the side wall 10. The pair of wall conductors 50 is arranged to extend from the top end 10a to the bottom end 10b. In this embodiment the side wall apertures 60 are arranged in two rows extending from the bottom end 10b part of the side wall 10 to the top end 10a of the side wall 10. The wall conductor 50 is arranged as a wall conductor pair such that first part of the wall conductor 50 is arranged in connection with the first row of side wall apertures 60 and the second part of the wall conductor 50 is arranged in connection with the second row of side wall apertures 60. Both parts of the conductor 50 are arranged inside the side wall 10 and such that part of the side wall apertures 60 is formed by the wall conductor 50.

In the invention the side wall 10 also comprises two support apertures 120 for the standing supports of the bottom structure and the wall conductor pair is arranged such that the wall conductor 50 forms part of the support aperture 120 such that when the standing support of the bottom structure comprises a conductor an electrical connection can be established between the wall conductor 50 and the conductor of the bottom structure.

Figure 2b shows the side wall 10 as shown in figure 2a as a side view. The side wall 10 has a first side surface 11 and a second side surface 12 extending between the top end 10a and the bottom end 10b and the side wall apertures 60 are arranged to extend from the first side surface 11 to the pair of conductors 50 arranged inside the side wall 10 such that the pair of conductors 50 form part of the side wall apertures 60 arranged in two rows extending in a longitudinal direction of the side wall 10, i.e. from the bottom end 10b to the top end 10a.

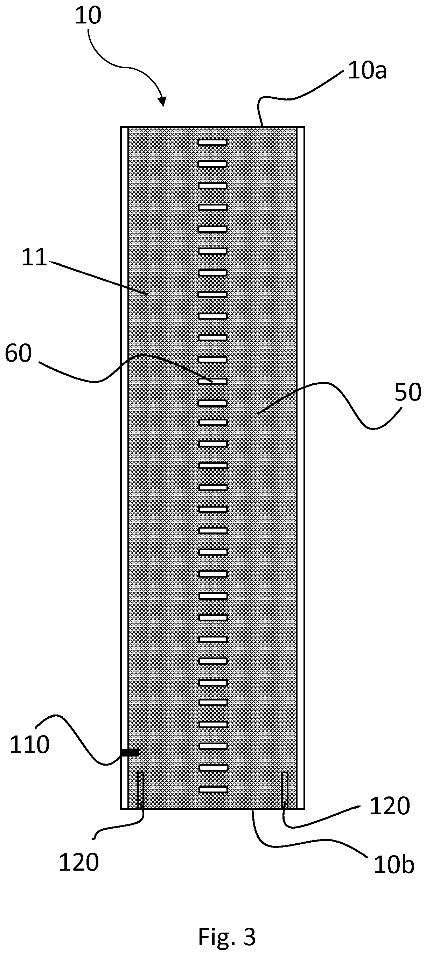

Figure 3 shows an example of a side wall 10 of a shelf system 1 not according to the invention. In this example the side wall 10 comprises a wall conductor 50 in a form of a wall conductor net arranged inside the side wall 10. The side wall apertures 60 are arranged to extend from the first side surface 11 to the wall conductor 50 and as the wall conductor 50 is in a form of a net the wall conductor 50 preferably forms the bottom of the side wall aperture 60. Although the example shown in figure 3 shows that the wall conductor 50 is arranged to extend from the top end 10a of the side wall 10 to the bottom end 10b of the side wall 10 it can be arranged to extend only part of the side wall 10. As the wall conductor 50 extends to the bottom end 10b of the side wall 10 the electrical connection can be made with a conductor of the bottom structure which is placed in the standing support of on the upper surface of the bottom structure.

Figure 3 shows also an example not according to the invention in which the power supply port 110 is arranged in the side wall 10 and an electrical connection can be connected to the power supply port 110 for providing electricity from a power source to the wall conductor 50. The power supply port 110 is connected to the wall conductor 50. When the power supply port 110 is provided in the side wall 10 there is no need for an electrical connection between the side wall 10 and the bottom structure but electricity can be transferred to wall conductors of other side walls through shelf plates comprising an electrical device. The electrical device may comprise an electrical connector arranged in the shelf plate 20 such that the electrical connector is in contact with the at least one of the two or more shelf supports 80. The one of the two or more shelf supports is in contact with the wall conductor 50 in the side wall 10.

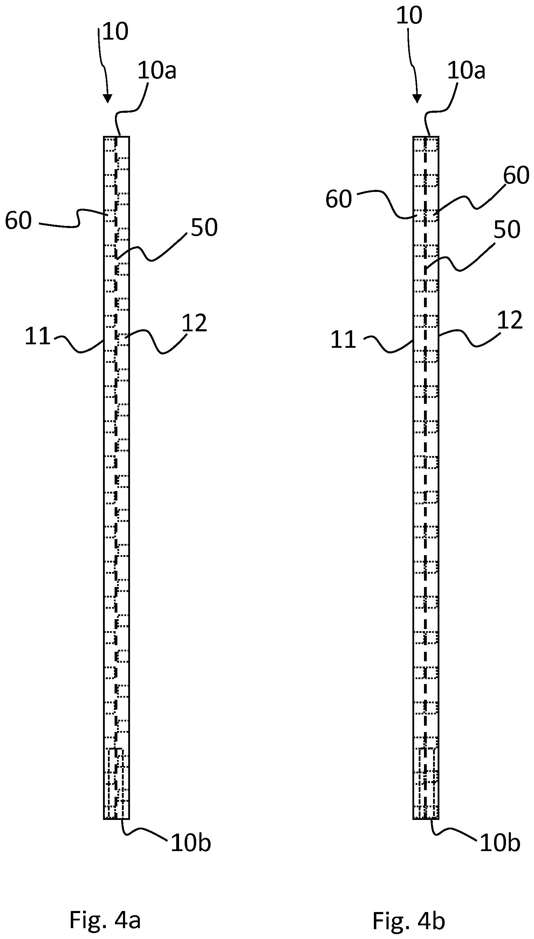

Figures 4a and 4b show that the side wall apertures 60 can be arranged on both sides of the side wall 10, i.e. the side wall 10 comprises side wall apertures 60 extending from the first side surface 11 to the wall conductor 50 and side wall apertures 60 extending from the second side wall surface 12 to the wall conductor 50. The side wall apertures 60 arranged on both sides of the side wall 10 can be arranged such that they are aligned or interleaved as shown in figure 4a and 4b.

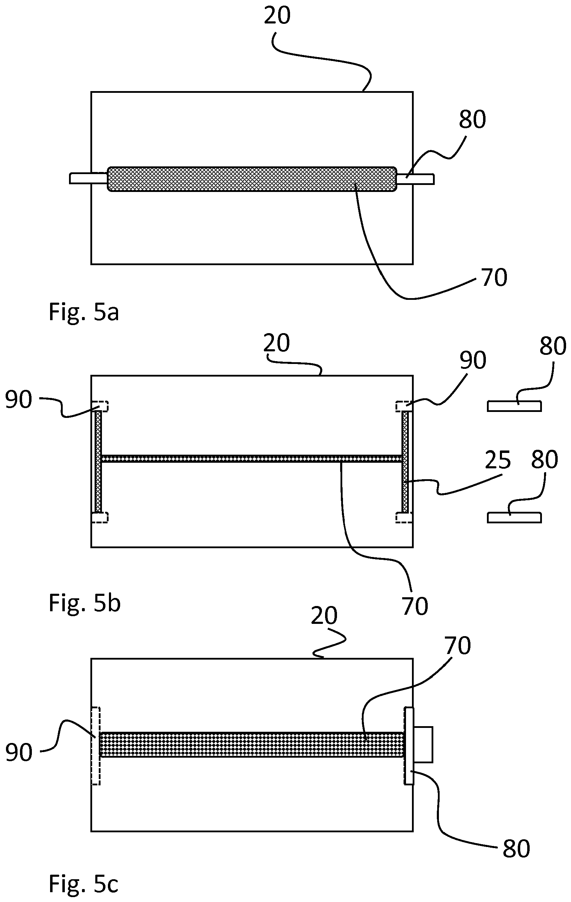

The shelf system 1 comprises one or more shelf plates 20 arranged between two side walls. Figures 5a-5c show different variations of a shelf plate 20 which the at least one of the one or more shelf plates comprises an electrical device 70.

Figure 5a shows a shelf plate 20 comprising an electrical device 70 being integrated in the shelf plate 20. The electrical device 70 in figure 5a can be for example an integral charging device. The electrical device 70 is connected to the wall conductor 50 (not shown in this figure) in the side wall 10 through a shelf support 80 which the shelf support 80 is in contact with the electrical device 70 and when provided in the side wall aperture 60 the shelf support 80 is in contact with the wall conductor 50. The shelf support 80 is made of electrically conductive material. Figure 5a shows an embodiment in which the shelf supports 80 are connected to the shelf plate 20. The connection between the shelf support 80 and the shelf plate 20 can be fixed such that the shelf support 80 is part of the shelf plate 20 or the connection between the shelf support 80 and the shelf plate 20 can be releasable such that the shelf support 80 is a separate piece connectable to the shelf plate 20. Another alternative is that the shelf support 80 is part of the side wall 80 forming an integral structure with the side wall 20. The electrical device 70 can be arranged to be inside the shelf plate 20 or the electrical device 70 can be form part of the outer surface of the shelf plate 20.

Figure 5b shows another example not according to the invention of a shelf plate 20 which the shelf plate 20 comprises shelf plate apertures 90 for the shelf supports 80. The shelf plate 20 comprises an electrical device 70 which can be for example a LED light strip. The electrical device 70 further comprises an electrical connector 25 arranged in the shelf plate 20 such that the electrical connector 25 is in contact with the at least one of the two or more shelf supports 80. The electrical connector is preferably arranged inside the shelf plate 20. In the example shown in figure 5b the electrical connector 25 is in contact with the shelf support 80 through the shelf plate aperture 90 when the shelf support 80 is provided in the aperture 90. In other words, the electrical connector 25 forms part of the shelf plate aperture 90 such that the electrical connection between the wall conductor 50 and the electrical connector 25 is possible through the shelf support 80. The electrical connector 25 can be for example electrical wiring or electrical connection of the electrical device 70. In still other words, the at least one of the one or more shelf plates 20 comprising the electrical device 25 further comprises a shelf plate aperture 90 for the at least one of the two or more shelf supports made of electrically conductive material, the electrical device forms part of the shelf plate aperture 90.

Figure 5c shows an example not according to the invention of the shelf plate 20 which comprises an electrical device 70 in contact with a shelf support 80. The shelf support 80 shown in figure 5c can be an integral part of the shelf plate 20 or as previously said a separate part. Also, the shelf plate 20 can comprise at least one integral shelf support 80 on the other end of the shelf plate 20 and a shelf plate aperture 90 in the opposing end of the shelf plate 20 as shown in figure 5c. In other words, the at least one of the two or more shelf supports is arranged to be integral with the at least one of the one or more shelf plates comprising an electrical device 70.

Figure 6 shows a shelf system 1 not according to the invention which comprises in this example two side walls 10 and two shelf plates 20 arranged between two side walls 10. The side walls 10 comprise side wall apertures 60 and a wall conductor 50 arranged to extend inside the side wall 10. The side wall apertures 60 extend from the first side surface 11 to the wall conductor 50 such that the wall conductor 50 forms part of the side wall aperture 60. The shelf plates 20 comprise an electrical device 70 which in this example is a light such as a LED light strip arranged in the shelf plate 20. The electrical device 70 is connected to the wall conductor 50 providing electricity to the electrical device 70 through shelf supports 80 arranged in the side wall apertures 60. The shelf supports 80 are in contact with the electrical device 70 and with the wall conductor 50 for transferring electricity to the electrical device 70.

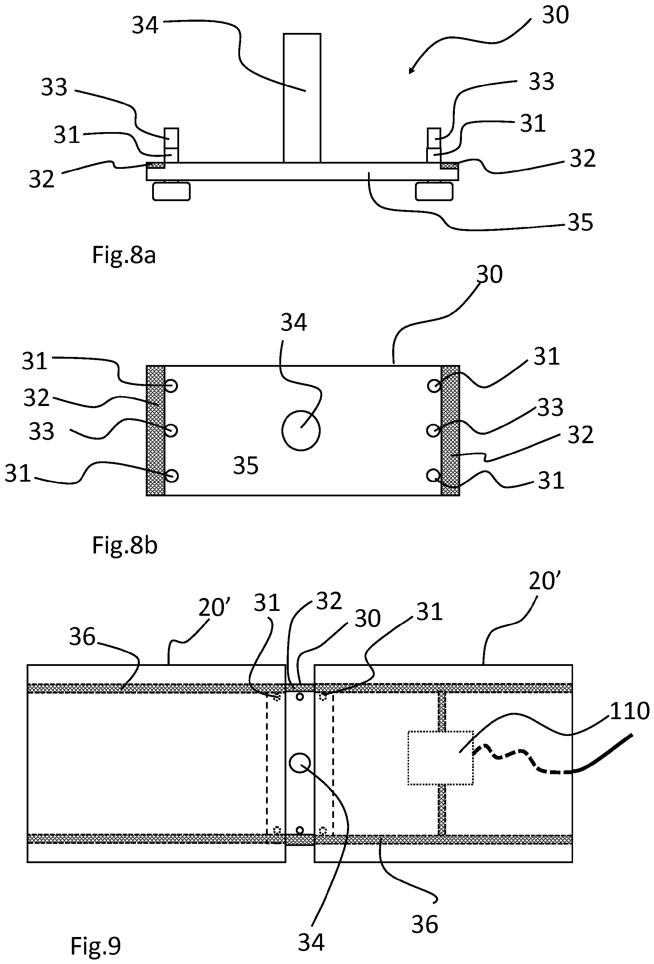

The shelf system 1 further comprises a bottom structure 100 comprising at least two base members 30, a bottom plate 20' arranged between two base members 30, and a coupling 31 connecting the bottom plate 20' and the two base members 30 together. In this example, the power supply from a power source to the shelf system is arranged through a power supply port 110 arranged in the base member 30 and the base member 30 comprises a base conductor 32 for transferring electricity. The bottom structure 100 is connected to the side wall 10 through the base member 30. The base member 30 comprises a base plate 35 and a standing support 34 (shown in figure 8a). The standing support 34 is arranged to protrude from the base plate 35 for providing a supporting bar for a side wall 10 comprising a support aperture 120 for the standing support 34 connecting the base member 30 and the side wall 10 together. The wall conductor 50 extends to the support aperture 120 and forms part of the support aperture 120 and the base conductor 32 extends to the standing support 34 such that when the standing support 34 is provided in the support aperture 120 an electrical connection is formed between the base member 30 and the side wall 10. Another possibility for transferring electricity from the base member 30 to the side wall 10 is that the wall conductor 50 extends to the bottom end 10b of the side wall 10 and the base conductor 32 is provided to the surface of the base member 30 such that the wall conductor 50 the base conductor 32 contact each other such that the wall conductor 50 and the base conductor 32 form an electrical connection.

The bottom plate 20' comprises a bottom conductor 36 which is connected to the base conductor 32 when the bottom plate 20' and the base member 30 are connected together. In other words, the bottom conductor 36 is electrically connected to the base conductor 32 through an electrical connection. The electrical connection can be a touch contact such that the base conductor 32 and the bottom conductor 36 touch each other for forming an electrical connection. Alternatively, the base conductor 32 and/or the bottom conductor 36 comprise a spring connector for forming an electrical connection between the base member 30 and the bottom plate 20'.

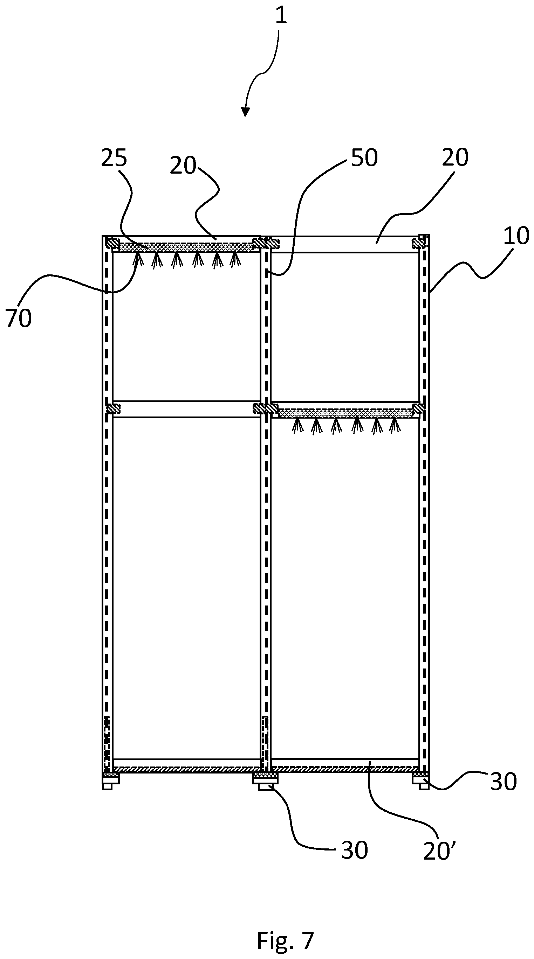

Figure 7 shows another example not according to invention in which the shelf system 1 comprises three side walls 10 and four shelf plates 20 provided between the side walls 10. Although it is not shown in the figure the side wall 10 arranged in the middle comprises side wall apertures 60 provided on both sides of the side wall 10 and the other side walls 10 preferably comprise side wall apertures 60 only on one side of the side wall 10. The side walls 10 comprise a wall conductor 50 arranged inside the side wall 10 and the side wall apertures 60 are arranged to extend from the first side surface 11 or from the first side surface 11 and from the second side surface 12 to the wall conductor 50. In this example two of the four shelf plates 20 comprise an electrical device 70 which in this example is a light system. The electrical device 70 comprises an electrical connector 25 extending to the shelf support 80 for having an electrical connection with the wall conductor 50 through the shelf support 80. The bottom structure 100 is similar as explained in connection with figure 6.

In another example not according to the invention shown in figure 8a the base member 30 comprises stabilizers 33 for providing means for adjustment of the balance of the base member 30 and the side wall 10 comprises corresponding apertures for the stabilizers. The base conductor 32 is arranged extend in side edges of the base member 30 such that when the side wall 10 is arranged on the upper surface of the base member 30 the wall conductor 50 extending to the bottom end 10b of the side wall 10 is in contact with the base conductor 32 of the base member 30. Figure 8b shows the base member 30 from above. The base member 30 also comprises a coupling 31 for connecting a bottom plate 20' to the base member 30. The coupling 31 can be for example a pin in the base member 30 and an aperture in the bottom plate or an aperture in the base member 30 and a pin in the bottom plate 20' or alternatively an aperture in the base member 30 and in the bottom plate 20' and a separate pin to be placed in the apertures.

In figure 9 two bottom plates 20' are connected to the base member 30. The connection between the base member 30 and the bottom plates 20' is provided through a coupling 31 connecting the bottom plate 20' to the two base members 30. As explained earlier the coupling 31 can be for example a pin coupling such that there is a pin in the base member and a corresponding aperture in the bottom plate 20' or vice versa.

The base conductor 32 is preferably arranged on the end edge of the base member 30 and the bottom conductor 36 in the bottom plate 20' is arranged to correspond the place of the base conductor 32 such that when the base member 30 and the bottom plate 20' are connected together through the coupling 31 the base conductor 36 and the bottom conductor 32 are electrically connected together. The base conductor 32 and/or the bottom conductor 36 preferably comprise a spring connector in the connection area, i.e. in the area where the base conductor 32 and the bottom conductor 36 meet each other and form an electrical connection.

In the example shown in figure 9 the power supply port 110 is arranged in the bottom plate 20' such that electrical power is supplied from the bottom conductor 36 of the bottom plate 20' to the base conductor 32 of the base member 30 and to the wall conductor 50 of the side wall 10 and through the shelf support 80 to the electrical device 70 in the shelf plate 20.

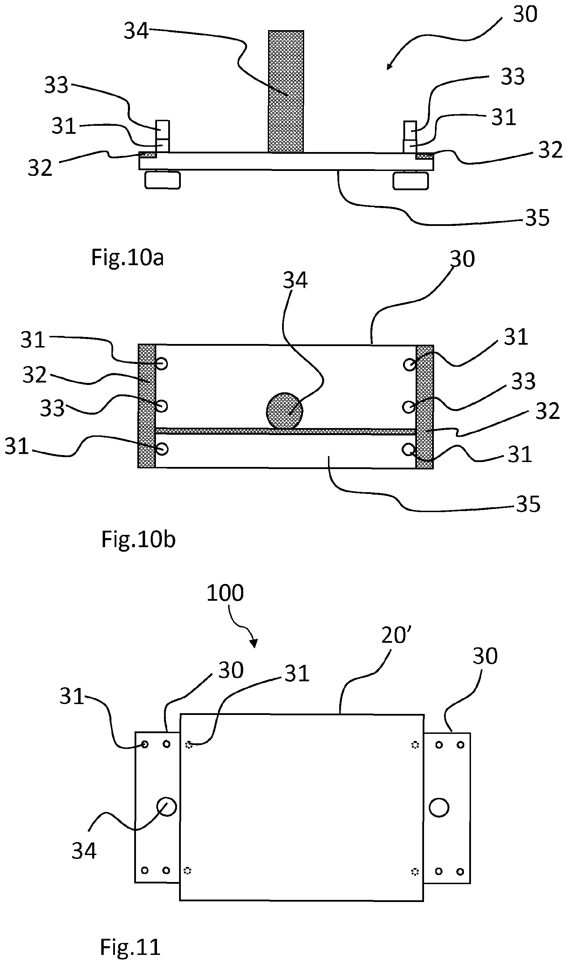

Figure 10a shows an example not according to the invention of the base member 30 which comprises a base conductor 32 arranged on a surface of a standing support 34. The base member 30 also comprises base conductors 30 on the edges of the base conductor 30 for providing an electrical connection to the bottom plates 20' connected to the base member 30. Figure 10b shows the base member 30 from above. The base conductors 32 arranged on the opposing edges of the base member 30 are connected with a base conductor extending through the surface of the base member 30. Although figures 10a and 10b show base conductors 32 on the upper surface of the base member, i.e. on the base plate 35 and on the surface of the standing support 34 it is not necessary to have both base conductors 32. The base conductors 32 arranged on the base plate 35 can transfer electricity between the bottom plate 20' and the base member 30 and between the base member 30 and the side wall 10 when the wall conductor 50 is arranged to extend to the bottom end 10b of the side wall 10.

Figure 11 shows part of the bottom structure 100 in which a bottom plate 20' is arranged between two base members 30 and connected through a coupling 31. In other words, a coupling 31 is connecting the bottom plate 20' and the two base members 30.

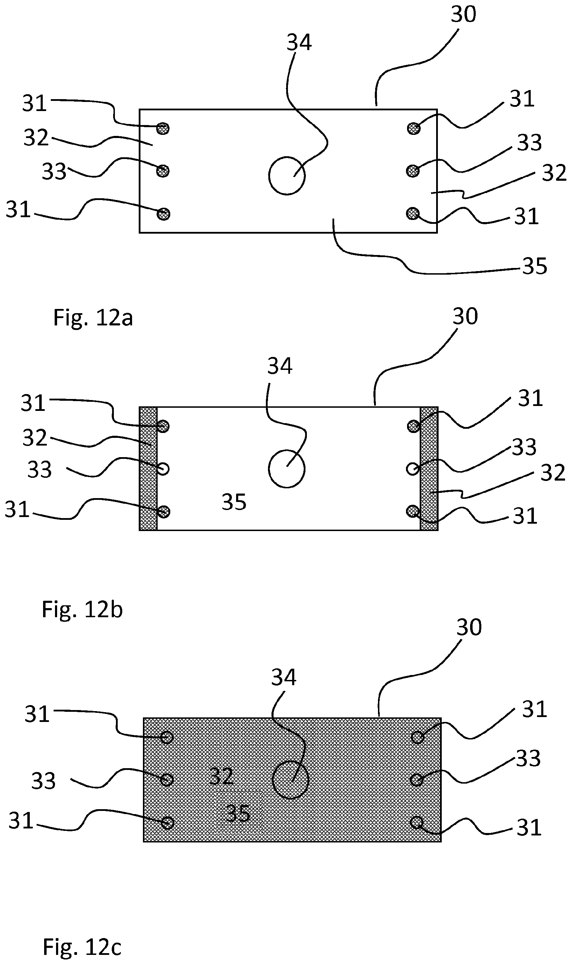

Figures 12a-12c show examples of the base member 30 comprising the base conductor 32. In figure 12a the base conductor is arranged in connection with the coupling 31 that connects the base member 30 and the bottom plate 20' together. The coupling can be an aperture in the base member 30 such that the bottom plate 20'comprises a corresponding pin with a conductor arranged in the pin or the coupling 31 can be a pin protruding from the base member 30 comprising conductor on the surface of the pin and the bottom plate 20' comprises a corresponding aperture with a conductor arranged in the aperture. Figure 12a also shows an alternative in which the stabilizer 33 to be inserted into the side wall 10 comprises a conductor for transferring electricity from the base member 30 to the side wall 10. The side wall comprises a corresponding aperture having an electrical connection to the conductor arranged inside the side wall for transferring electricity from the conductor in the stabilizer 33 to the wall conductor 50.

Figure 12b shows an example in which the base member comprises a base conductor 32 arranged on the edge areas of the base member 30 and the couplings 31 are also provided with conductors. The base conductor 32 is arranged to be connected to the wall conductor 50 in the side wall 10 such that the side wall comprises a connection area in the bottom end 10b of the side wall 10 in which the wall conductor 50 is provided and capable of making an electrical connection with the base conductor 32 in the base member 30. The wall conductor 50 may comprise in the area of the bottom end 10b of the side wall 10 a spring, a ball or other suitable connector for making an electrical connection. The electrical connection may be provided between the wall conductor 50 and the base conductor 32 also by a contact connection. The side wall 10 is provided with the wall conductor 50 arranged inside the side wall 10 and further a spring connector connected to the wall conductor 50. The spring connector is provided in the bottom end 10b of the side wall 10 such that the spring connector is capable of making an electrical connection with the base conductor 32 in the base member 30. In an embodiment of the invention the spring connector is provided in the bottom end 10b of the side wall 10 such that when the side wall 10 and the base member 30 are connected together, the spring connector is provided in the connection between the base member 30 and the side wall 10 such that the spring connector does not carry or wedge the connection between the base member 30 and the side wall 10 or does not in any way provide any visible changes as seen from outside of the shelf system. In other words, the spring connector is provided inside the connection between the base member 30 and the side wall 10. The spring connector can be for example be provided in connection with an aperture in the bottom end 10b of the side wall 10.

Figure 12c shows an example in which the base conductor 32 is arranged in the upper surface of the base member 30. The conductor may also be provided in connection with the coupling 31, the stabilizer 33 and the standing support 34.

The invention has been described above with reference to the examples shown in the figures. However, the invention is in no way restricted to the above examples but may vary within the scope of the claims.

## Claims

1. A shelf system (1) comprising:
- two or more side walls (10), each side wall (10) comprising a top end (10a) and a bottom end (10b) and a first side surface (11) extending between the top end (10a) and the bottom end (10b) and a second side surface (12) extending between the top end (10a) and the bottom end (10b), the side walls (10) further comprising side wall apertures (60) extending from the first side surface (11) inwards into the side wall (10);
- one or more shelf plates (20) arranged between two side walls (10), at least one of the one or more shelf plates (20) comprising an electrical device (70); and
- two or more shelf supports (80) provided in the side wall apertures (60) for supporting the one or more shelf plates (20) to the side walls (10); wherein at least one of the two or more side walls (10) comprises
- a wall conductor (50) arranged in the side wall (10) to extend inside the side wall (10) between the top end (10a) and the bottom end (10b); and
- at least one of the side wall apertures (60) extending from the first side surface (11) to the wall conductor (50) arranged inside the side wall (10);
and
at least one of the two or more shelf supports (80) is made of electrically conductive material and arranged in contact with the wall conductor (50) inside the side wall (10) and further in contact with the electrical device (70) in the shelf plate (20), said at least one of the two or more shelf supports (80) is arranged to provide an electrical connection between the wall conductor (50) and the electrical device (70), the shelf support (80) is a separate piece connectable to the shelf plate (20), the shelf plate (20) comprising the electrical device (70) integrated in the shelf plate (20), the shelf supports (80) are connected to the shelf plate (20) and the connection between the shelf support (80) and the shelf plate (20) is releasable,
the shelf system (1) further comprises a bottom structure (100), the side walls (10) are supported by the bottom structure (100), the bottom structure (100) comprising:
- at least two base members (30);
- a bottom plate (20') arranged between the two base members (30), and
- a coupling (31) connecting the bottom plate (20') to the two base members (30), the bottom structure (100) is connected to the side wall (10) through the base member (30) comprising a base conductor (32), and an electrical connection is formed between the wall conductor (50) extending to the bottom end (10b) of the side wall (10) and the base conductor (32), the bottom plate (20') comprises a bottom conductor (36) which is electrically connected to the base conductor (32) through an electrical connection,
the side wall comprises a pair of conductors (50) arranged inside the side wall (10),
the side wall apertures (60) are arranged in two rows extending from the bottom end part of the side wall (10) to the top end of the side wall (10),
the wall conductor (50) is arranged as a wall conductor pair such that first part of the wall conductor is arranged in connection with the first row of side wall apertures and the second part of the wall conductor is arranged in connection with the second row of the side wall apertures, both parts of the conductor are arranged inside the side wall and such that part of the side wall apertures is formed by the wall conductor (50), and
two support apertures (120) for the standing supports of the bottom structure wherein the wall conductor pair is arranged such that the wall conductor (50) forms part of the support aperture (120) such that when the standing support of the bottom structure comprises a conductor, an electrical connection can be established between the wall conductor (50) and the conductor of the bottom structure.

2. A shelf system (1) according to claim 1, **characterized in that** the wall conductor (50) is an electrical wire, an electrical strip or a plate conductor set as a single conductor, as a conductor pair, as a set of conductors or as a conductor net inside the side wall (10).

3. A shelf system (1) according to claim 1 or 2, **characterized in** the at least one of the side wall apertures (60) is arranged as a blind hole in the side wall (10) such that the wall conductor (50) forms part of the blind hole.

4. A shelf system (1) according to any previous claim, **characterized in that** the electrical device (70) comprises an electrical connector (25) arranged in the shelf plate (20) such that the electrical connector (25) is in contact with the at least one of the two or more shelf supports (80).

5. A shelf system (1) according to claim 4, **characterized in that** the electrical connector (25) is arranged inside the shelf plate (20).

6. A shelf system (1) according to any previous claim, **characterized in that** the electrical device (70) is a light source, an USB connector, a loudspeaker, an electrical socket, a wireless charging platform, a camera or a screen.

7. A shelf system (1) according to any previous claim, **characterized in that** the at least one of the one or more shelf plates (20) comprising the electrical device (70) further comprises a shelf plate aperture (90) for the at least one of the two or more shelf supports (80) made of electrically conductive material, the electrical device (70) forms part of the shelf plate aperture (90).

8. A shelf system (1) according to any previous claim, **characterized in that** the at least one of the two or more shelf supports (80) is arranged to be integral with the at least one of the one or more shelf plates (20) comprising an electrical device (70).

9. A shelf system (1) according to any previous claim, **characterized in that** the wall conductor (50) is arranged to extend inside the side wall (10) to the bottom end (10b) of the side wall (10) such that the wall conductor (50) forms part of the bottom end (10b) of the side wall (10).

10. A shelf system (1) according to any previous claim, **characterized in that** the wall conductor (50) is arranged to extend to the bottom end (10b) of the side wall (10) such that the wall conductor (50) forms an electrical connection with the base conductor (32) arranged on a surface of the base member (30) contacting the bottom end (10b) of the side wall (10).

11. A shelf system (1) according to any previous claim, **characterized in that** power supply to the shelf system (1) is arranged through a power supply port (110);
said power supply port (110) is arranged in the base member (30); or
said power supply port (110) is arranged in the bottom plate (20').

12. A shelf system (1) according to any previous claim, **characterized in that** power supply to the shelf system (1) is arranged through a power supply port (110), said power supply port (110) is arranged in the at least one of the two or more side walls (10).

## Patentansprüche

1. Regalsystem (1), umfassend:
- zwei oder mehrere Seitenwände (10), wobei jede Seitenwand (10a) ein oberes Ende (10a) und ein unteres Ende (10b) und eine erste Seitenfläche (11), die sich zwischen dem oberen Ende (10a) und dem unteren Ende (10b) erstreckt, und eine zweite Seitenfläche (12), die sich zwischen dem oberen Ende (10a) und dem unteren Ende (10b) erstreckt, umfasst, wobei die Seitenwände (10) weiter Seitenwandöffnungen (60) umfassen, die sich von der ersten Seitenfläche (11) nach innen in die Seitenwand (10) erstrecken;
- eine oder mehrere Regalplatten (20), die zwischen zwei Seitenwänden (10) eingerichtet sind, wobei mindestens eine der einen oder mehreren Seitenplatten (20) eine elektrische Vorrichtung (70) umfasst; und
- zwei oder mehrere Regalhalterungen (80), in den Seitenwandöffnungen (60) bereitgestellt, zum Halten der einen oder mehreren Regalplatten (20) an die Seitenwände (10);
wobei mindestens eine der zwei oder mehreren Seitenwände (10) umfasst
- einen Wandleiter (50), in der Seitenwand (10) eingerichtet, um sich innerhalb der Seitenwand (10) zwischen dem oberen Ende (10a) und dem oberen Ende (10b) zu erstrecken; und
- wobei sich mindestens eine der Seitenwandöffnungen (60) von der ersten Seitenfläche (11) zum Wandleiter (50), der innerhalb der Seitenwand (10) eingerichtet ist, erstreckt;
und
mindestens eine der zwei oder mehreren Regalhalterungen (80) aus elektrisch leitfähigem Material hergestellt ist und in Kontakt mit dem Wandleiter (50) innerhalb der Seitenwand (10) und weiter in Kontakt mit der elektrischen Vorrichtung (70) in der Regalplatte (20) eingerichtet ist, wobei mindestens eine der zwei oder mehreren Regalhalterungen (80) eingerichtet ist, um eine elektrische Verbindung zwischen dem Wandleiter (50) und der elektrischen Vorrichtung (70) bereitzustellen, wobei die Regalhalterung (80) ein separates Bauteil ist, das mit der Regalplatte (20) verbunden werden kann, wobei die Regalplatte (20) die elektrische Vorrichtung (70) integriert in der Regalplatte (20) umfasst, die Regalhalterungen (80) mit der Regalplatte (20) verbunden sind und die Verbindung zwischen der Regalhalterung (80) und der Regalplatte (20) abnehmbar ist,
das Regalsystem (1) weiter eine Bodenstruktur (100) umfasst, die Seitenwände (10) von der Bodenstruktur (100) gehalten werden, wobei die Bodenstruktur (100) umfasst:
- mindestens zwei Basiselemente (30);
- eine Bodenplatte (20'), die zwischen den zwei Basiselementen (30) eingerichtet ist, und
- eine Kopplung (31), die die Bodenplatte (20') mit den zwei Basiselementen (30) verbindet, wobei die Bodenstruktur (100) durch das Basiselement (30), das einen Basisleiter (32) umfasst, mit der Seitenwand (10) verbunden ist und eine elektrische Verbindung zwischen dem Wandleiter (50), der sich zum unteren Ende (10b) der Seitenwand (10) erstreckt, und dem Basisleiter (32) gebildet ist, wobei die Bodenplatte (20') einen Bodenleiter (36) umfasst, der durch eine elektrische Verbindung mit dem Basisleiter (32) elektrisch verbunden ist,
die Seitenwand ein Paar von Leitern (50) umfasst, die innerhalb der Seitenwand (10) eingerichtet sind,
die Seitenwandöffnungen (60) in zwei Reihen eingerichtet sind, die sich vom unteren Endteil der Seitenwand (10) zum oberen Ende der Seitenwand (10) erstrecken,
der Wandleiter (50) derart als ein Wandleiterpaar eingerichtet ist, dass ein erster Teil des Wandleiters in Verbindung mit der ersten Reihe von Seitenwandöffnungen eingerichtet ist und der zweite Teil des Wandleiters in Verbindung mit der zweiten Reihe der Seitenwandöffnungen eingerichtet ist, wobei beide Teile des Leiters innerhalb der Seitenwand und derart eingerichtet sind, dass ein Teil der Seitenwandöffnungen vom Wandleiter (50) gebildet wird, und
zwei Halterungsöffnungen (120) für die stehenden Halterungen der Bodenstruktur, wobei das Wandleiterpaar derart eingerichtet ist, dass der Wandleiter (50) derart einen Teil der Halterungsöffnung (120) bildet, dass eine elektrische Verbindung zwischen der Wandstruktur (50) und dem Leiter der Bodenstruktur aufgebaut werden kann, wenn die stehende Halterung der Bodenstruktur einen Leiter umfasst.

2. Regalsystem (1) nach Anspruch 1, **dadurch gekennzeichnet, dass** der Wandleiter (50) ein elektrischer Draht, ein elektrischer Streifen oder ein Plattenleiter ist, der als ein einziger Leiter, als ein Leiterpaar, als ein Satz von Leitern oder als ein Leiternetzwerk innerhalb der Seitenwand (10) eingestellt ist.

3. Regalsystem (1) nach Anspruch 1 oder 2, **dadurch gekennzeichnet, dass** mindestens eine der Seitenwandöffnungen (60) derart als ein Blindloch in der Seitenwand (10) eingerichtet ist, dass der Wandleiter (50) einen Teil des Blindlochs bildet.

4. Regalsystem (1) nach einem vorstehenden Anspruch, **dadurch gekennzeichnet, dass** die elektrische Vorrichtung (70) ein elektrisches Verbindungsstück (25) umfasst, das derart in der Regalplatte (20) eingerichtet ist, dass das elektrische Verbindungsstück (25) mit der mindestens einen der zwei oder mehreren Regalhalterungen (80) in Kontakt ist.

5. Regalsystem (1) nach Anspruch 4, **dadurch gekennzeichnet, dass** das elektrische Verbindungsstück (25) innerhalb der Regalplatte (20) eingerichtet ist.

6. Regalsystem (1) nach einem vorstehenden Anspruch, **dadurch gekennzeichnet, dass** die elektrische Vorrichtung (70) eine Lichtquelle, ein USB-Anschluss, ein Lautsprecher, eine Steckdose, eine drahtlose Ladeplattform, eine Kamera oder ein Bildschirm ist.

7. Regalsystem (1) nach einem vorstehenden Anspruch, **dadurch gekennzeichnet, dass** die mindestens eine der einen oder mehreren Regalplatten (20), die die elektrische Vorrichtung (70) umfasst, weiter eine Regalplattenöffnung (90) für die mindestens eine der zwei oder mehreren Regalhalterungen (80) umfasst, die aus elektrisch leitfähigem Material hergestellt ist, wobei die elektrische Vorrichtung (70) einen Teil der Regalplattenöffnung (90) bildet.

8. Regalsystem (1) nach einem vorstehenden Anspruch, **dadurch gekennzeichnet, dass** die mindestens eine der zwei oder mehreren Regalhalterungen (80) eingerichtet ist, um integral mit der mindestens einen der einen oder mehreren Regalplatten (20) zu sein, die eine elektrische Vorrichtung (70) umfassen.

9. Regalsystem (1) nach einem vorstehenden Anspruch, **dadurch gekennzeichnet, dass** der Wandleiter (50) eingerichtet ist, um sich innerhalb der Seitenwand (10) derart zum unteren Ende (10b) der Seitenwand (10) zu erstrecken, dass der Wandleiter (50) einen Teil des unteren Endes (10b) der Seitenwand (10) bildet.

10. Regalsystem (1) nach einem vorstehenden Anspruch, **dadurch gekennzeichnet, dass** der Wandleiter (50) eingerichtet ist, um sich derart zum unteren Ende (10b) der Seitenwand (10) zu erstrecken, dass der Wandleiter (50) eine elektrische Verbindung mit dem Basisleiter (32) bildet, der an einer Fläche des Basiselements (30) eingerichtet ist, die das untere Ende (10b) der Seitenwand (10) kontaktiert.

11. Regalsystem (1) nach einem vorstehenden Anspruch, **dadurch gekennzeichnet, dass** Stromversorgung für das Regalsystem (1) durch einen Stromversorgungsanschluss (110) eingerichtet ist;
wobei der Stromversorgungsanschluss (110) im Basisteil (30) eingerichtet ist; oder
wobei der Stromversorgungsanschluss (110) in der Bodenplatte (20') eingerichtet ist.

12. Regalsystem (1) nach einem vorstehenden Anspruch, **dadurch gekennzeichnet, dass** Stromversorgung für das Regalsystem (1) durch einen Stromversorgungsanschluss (110) eingerichtet ist, wobei der Stromversorgungsanschluss (110) in der mindestens einen der zwei oder mehreren Seitenwände (10) eingerichtet ist.

## Revendications

1. Système de rayonnage (1) comprenant :
- deux ou plusieurs parois latérales (10), chaque paroi latérale (10) comprenant une extrémité supérieure (10a) et une extrémité inférieure (10b) et une première surface latérale (11) s'étendant entre l'extrémité supérieure (10a) et l'extrémité inférieure (10b) et une seconde surface latérale (12) s'étendant entre l'extrémité supérieure (10a) et l'extrémité inférieure (10b), les parois latérales (10) comprenant en outre des ouvertures de parois latérales (60) s'étendant de la première surface latérale (11) vers l'intérieur dans la paroi latérale (10) ;
- une ou plusieurs planches de rayonnage (20) disposées entre deux parois latérales (10), au moins l'une parmi la ou les planches de rayonnage (20) comprenant un dispositif électrique (70) ; et
- deux ou plusieurs supports de rayonnage (80) étant prévus dans les ouvertures de parois latérales (60) pour soutenir la ou les planches de rayonnage (20) par rapport aux parois latérales (10) ;
dans lequel au moins l'une parmi les deux ou plusieurs parois latérales (10) comprend
- un conducteur de paroi (50) disposé dans la paroi latérale (10) pour s'étendre à l'intérieur de la paroi latérale (10) entre l'extrémité supérieure (10a) et l'extrémité inférieure (10b) ; et
- au moins l'une des ouvertures de parois latérales (60) s'étendant de la première surface latérale (11) vers le conducteur de paroi (50) étant disposée à l'intérieur de la paroi latérale (10) ;
et
au moins l'un parmi les deux ou plusieurs supports de rayonnage (80) est fabriqué à partir d'un matériau électroconducteur et disposé de manière à entrer en contact avec le conducteur de paroi (50) à l'intérieur de la paroi latérale (10) et en outre de manière à entrer en contact avec le dispositif électrique (70) dans la planche de rayonnage (20), ledit au moins un support parmi les deux ou plusieurs supports de rayonnage (80) est disposé pour établir un raccordement électrique entre le conducteur de paroi (50) et le dispositif électrique (70), le support de rayonnage (80) est une pièce distincte pouvant être raccordée à la planche de rayonnage (20), la planche de rayonnage (20) comprenant le dispositif électrique (70) intégré à la planche de rayonnage (20), les supports de rayonnage (80) sont raccordés à la planche de rayonnage (20) et le raccordement entre le support de rayonnage (80) et la planche de rayonnage (20) est amovible,
le système de rayonnage (1) comprend en outre une structure inférieure (100), les parois latérales (10) sont soutenues par la structure inférieure (100), la structure inférieure (100) comprenant :
- au moins deux éléments de base (30) ;
- une planche inférieure (20') disposée entre les deux éléments de base (30), et
- un système de couplage (31) raccordant la planche inférieure (20') aux deux éléments de base (30), la structure inférieure (100) est raccordée à la paroi latérale (10) par l'élément de base (30) comprenant un conducteur de base (32), et un raccordement électrique est formé entre le conducteur de paroi (50) s'étendant vers l'extrémité inférieure (10b) de la paroi latérale (10) et le conducteur de base (32), la planche inférieure (20') comprend un conducteur inférieur (36) qui est raccordé électriquement au conducteur de base (32) par un raccordement électrique,
la paroi latérale comprend une paire de conducteurs (50) disposée à l'intérieur de la paroi latérale (10),
les ouvertures de parois latérales (60) sont disposées en deux rangées s'étendant de la partie d'extrémité inférieure de la paroi latérale (10) à l'extrémité supérieure de la paroi latérale (10),
le conducteur de paroi (50) est disposé comme une paire de conducteurs de paroi de sorte que la première partie du conducteur de paroi est disposée de manière à être raccordée à la première rangée des ouvertures de parois latérales et la seconde partie du conducteur de paroi est disposée de manière à être raccordée à la seconde rangée des ouvertures de parois latérales, les deux parties du conducteur sont disposées à l'intérieur de la paroi latérale et de sorte qu'une partie des ouvertures de parois latérales est formée par le conducteur de paroi (50), et
deux ouvertures de support (120) destinées aux supports verticaux de la structure inférieure, dans lequel la paire de conducteurs de paroi est disposée de sorte que le conducteur de paroi (50) fait partie intégrante de l'ouverture de support (120) de sorte que lorsque le support vertical de la structure inférieure comprend un conducteur, un raccordement électrique peut être établi entre le conducteur de paroi (50) et le conducteur de la structure inférieure.

2. Système de rayonnage (1) selon la revendication 1, **caractérisé en ce que** le conducteur de paroi (50) est un fil électrique, une bande électrique ou un conducteur en plaque fixé comme un conducteur unique, comme une paire de conducteurs, comme une série de conducteurs ou comme un réseau de conducteurs à l'intérieur de la paroi latérale (10).

3. Système de rayonnage (1) selon la revendication 1 ou 2, **caractérisé en ce que** l'au moins une des ouvertures de parois latérales (60) est disposée comme un trou aveugle dans la paroi latérale (10) de sorte que le conducteur de paroi (50) fait partie intégrante du trou aveugle.

4. Système de rayonnage (1) selon l'une quelconque des revendications précédentes, **caractérisé en ce que** le dispositif électrique (70) comprend un connecteur électrique (25) disposé dans la planche de rayonnage (20) de sorte que le connecteur électrique (25) est en contact avec l'au moins un parmi les deux ou plusieurs supports de rayonnage (80).

5. Système de rayonnage (1) selon la revendication 4, **caractérisé en ce que** le connecteur électrique (25) est disposé à l'intérieur de la planche de rayonnage (20).

6. Système de rayonnage (1) selon l'une quelconque des revendications précédentes, **caractérisé en ce que** le dispositif électrique (70) est une source lumineuse, un connecteur USB, un haut-parleur, une prise électrique, une plateforme de chargement sans fil, une caméra ou un écran.

7. Système de rayonnage (1) selon l'une quelconque des revendications précédentes, **caractérisé en ce que** l'au moins une parmi la ou les planches de rayonnage (20) comprenant le dispositif électrique (70) comprend en outre une ouverture de planche de rayonnage (90) destinée à l'au moins un parmi les deux ou plusieurs supports de rayonnage (80) fabriqué à partir d'un matériau électroconducteur, le dispositif électrique (70) fait partie intégrante de l'ouverture de plaque de rayonnage (90).

8. Système de rayonnage (1) selon l'une quelconque des revendications précédentes, **caractérisé en ce que** l'au moins un parmi les deux ou plusieurs supports de rayonnage (80) est disposé de manière à faire partie intégrante du au moins une parmi la ou les planches de rayonnage (20) comprenant un dispositif électrique (70).

9. Système de rayonnage (1) selon l'une quelconque des revendications précédentes, **caractérisé en ce que** le conducteur de paroi (50) est disposé de manière à s'étendre à l'intérieur de la paroi latérale (10) par rapport à l'extrémité inférieure (10b) de la paroi latérale (10) de sorte que le conducteur de paroi (50) fait partie intégrante de l'extrémité inférieure (10b) de la paroi latérale (10).

10. Système de rayonnage (1) selon l'une quelconque des revendications précédentes, **caractérisé en ce que** le conducteur de paroi (50) est disposé de manière à s'étendre par rapport à l'extrémité inférieure (10b) de la paroi latérale (10) de sorte que le conducteur de paroi (50) forme un raccordement électrique avec le conducteur de base (32) disposé sur une surface de l'élément de base (30) de manière à entrer en contact avec l'extrémité inférieure (10b) de la paroi latérale (10).

11. Système de rayonnage (1) selon l'une quelconque des revendications précédentes, **caractérisé en ce que** l'alimentation électrique du système de rayonnage (1) est disposée à travers un port d'alimentation électrique (110) ;
ledit port d'alimentation électrique (110) est disposé dans l'élément de base (30) ; ou
ledit port d'alimentation électrique (110) est disposé dans la planche inférieure (20').

12. Système de rayonnage (1) selon l'une quelconque des revendications précédentes, **caractérisé en ce que** l'alimentation électrique du système de rayonnage (1) est disposée à travers un port d'alimentation électrique (110), ledit port d'alimentation électrique (110) est disposé dans l'au moins une parmi les deux ou plusieurs parois latérales (10).
